# EUROPÄISCHE PATENTSCHRIFT

(11) **EP 4 647 726 B1**
(45) Veröffentlichungstag und Bekanntmachung des Hinweises auf die Patenterteilung: **11.11.2026**
(21) Anmeldenummer: 25162561.2
(22) Anmeldetag: 10.03.2025
(51) Int. Cl.: G01D 5/14, G01D 5/20

(54) **POSITIONSMESSEINRICHTUNG**
POSITION MEASURING DEVICE
DISPOSITIF DE MESURE DE POSITION

(30) Priorität: 07.05.2024 DE 102024001488
(43) Veröffentlichungstag der Anmeldung: 12.11.2025
(73) Patentinhaber: Dr. Johannes Heidenhain GmbH, 83301 Traunreut (DE)
(72) Erfinder: Ollert, Udo, 84558 Kirchweidach (DE); Hilverkus, Johannes, 83250 Marquartstein (DE); Schneider, Johannes, 83278 Traunstein (DE)

(56) Entgegenhaltungen:
- EP-A1- 4 092 678
- DE-A1- 102020 107 433
- DE-A1- 102022 106 330

## Beschreibung

### GEBIET DER TECHNIK

Die Erfindung betrifft eine Positionsmesseinrichtung mit einem Domänenwandspeicher zur Speicherung von Umdrehungs- oder Positionsinformationen beispielsweise für eine Winkel- beziehungsweise Längenmesseinrichtung gemäß dem Anspruch 1.

Winkelmesseinrichtungen werden beispielsweise als Drehgeber zur Bestimmung der Winkellage zweier relativ zueinander drehbarer Maschinenteile verwendet. Häufig werden zu diesem Zweck so genannte Multi-Turn-Winkelmesseinrichtungen eingesetzt, durch die eine absolute Positionsbestimmung über viele Umdrehungen hinweg möglich ist.

Darüber hinaus sind Längenmesseinrichtungen bekannt, bei denen eine lineare Verschiebung zweier relativ zueinander verschiebbarer Maschinenteile gemessen wird. Insbesondere bei Längenmesseinrichtungen mit vergleichsweise großer Messlänge werden oft mehrere Linearmaßstäbe oder identische Skalen in Messrichtung aneinandergereiht. Bei derartigen Längenmesseinrichtungen soll eine absolute Positionsbestimmung bestenfalls über die gesamte Messlänge möglich sein.

Häufig werden derartige Messeinrichtungen beziehungsweise Messgeräte für elektrische Antriebe zur Bestimmung der Relativbewegung beziehungsweise der Relativlage von entsprechenden Maschinenteilen eingesetzt. In diesem Fall werden die erzeugten Positionswerte einer Folgeelektronik zur Ansteuerung der Antriebe über eine entsprechende Schnittstellenanordnung zugeführt.

Für viele Anwendungen von Positionsmesseinrichtungen, insbesondere von Winkelmess- oder Längenmesseinrichtungen, ist es wichtig zumindest Umdrehungsanzahlen oder Grobpositionen nicht flüchtig zu speichern.

### STAND DER TECHNIK

In der EP 4 170 289 A1 der Anmelderin wird eine Positionsmesseinrichtung zur Messung einer Winkelstellung beschrieben, die auf einem induktiven Messprinzip beruht.

Zudem offenbart die Druckschrift EP 3 387 387 B1 einen magnetischen Umdrehungszähler mit einem Domänenwandspeicher.

Weiterhin zeigt die Druckschrift EP 4 092 678 A1 eine Winkelmesseinrichtung mit einer durch eine Detektoreinheit abgetasteten Skala sowie einem Domänenwandleiter.

### ZUSAMMENFASSUNG DER ERFINDUNG

Der Erfindung liegt die Aufgabe zugrunde eine Positionsmesseinrichtung mit einem Domänenwandspeicher zu schaffen, die vergleichsweise einfach und platzsparend aufgebaut ist und präzise arbeitet.

Diese Aufgabe wird erfindungsgemäß durch die Merkmale des Anspruches 1 gelöst.

Demnach umfasst die Positionsmesseinrichtung eine erste Bauteilgruppe und eine zweite Bauteilgruppe, wobei die Bauteilgruppen in einer Messrichtung relativ zueinander beweglich angeordnet sind. Die erste Bauteilgruppe weist eine erste Leiterplatte auf, die eine Detektoreinheit umfasst. Außerdem weist die erste Bauteilgruppe eine zweite Leiterplatte auf, die einen Domänenwandleiter umfasst. Die erste Leiterplatte ist in der Messrichtung versetzt zur zweiten Leiterplatte angeordnet. Die zweite Bauteilgruppe umfasst eine Skala und zumindest einen Magnet. Die Skala ist zwischen dem Magnet und der zweiten Leiterplatte angeordnet. Zur Bestimmung der Relativposition zwischen der Skala und der Detektoreinheit in Messrichtung ist die Skala von der Detektoreinheit abtastbar. Der zumindest eine Magnet ist so ausgebildet und angeordnet, dass durch diesen eine Verschiebung zumindest einer Domänenwand im Domänenwandleiter bei einer Vorbeifahrt des Magnets erzeugbar ist.

Ein Domänenwandleiter besteht aus einem magnetisierbaren Material und ist im Zusammenhang mit der vorliegenden Erfindung insbesondere als zumindest eine Leiterspur beziehungsweise Leiterbahn oder ein Nanodraht ausgestaltet. Der Domänenwandleiter verläuft auf einem Substrat. In dem Domänenwandleiter kann Information in Form von gegensätzlich magnetisierten Regionen (Domänen) gespeichert werden. Die Domänen sind entlang der Leiterspur durch so genannte Domänenwände getrennt, die durch Magnetfelder verschoben werden können, wobei sich die Positionen der Domänen ändern. Ein derartiger Domänenwandleiter kann von einem Gehäuse ummantelt sein, das elektronische Anschlussstellen, wie etwa Pins, Leads oder Balls umfasst. Das Gehäuse dient dazu, den Domänenwandspeicher auf der zweiten Leiterplatte zu befestigen.

Die Skala kann beispielsweise auf einer ersten Seite eines Substrats aufgebracht sein und an der gegenüber liegenden Seite des Substrats kann der zumindest eine Magnet angeordnet sein. Alternativ kann auf dem zumindest einen Magnet die Skala aufgebracht sein, so dass der Magnet als tragendes Substrat dient, was die Anzahl der erforderlichen Teile der zweiten Bauteilgruppe reduziert.

Mit Vorteil ist der Domänenwandleiter in einem Gehäuse angeordnet, welches auf einer ersten Oberfläche der zweiten Leiterplatte montiert ist. Eine erste Distanz zwischen der Skala und der Detektoreinheit weist eine erste Länge auf. Eine zweite Distanz zwischen der ersten Oberfläche und der Skala weist eine zweite Länge auf. Es gilt, dass die erste Länge kleiner ist als die zweite Länge oder zumindest gleich der zweiten Länge ist. Die erste und zweite Distanz bzw. die erste und zweite Länge erstrecken sich in einer dritten Richtung, die orthogonal zur Messrichtung orientiert ist.

Für den Fall, dass die Skala oder die Detektoreinheit so ausgestaltet sein sollten, dass sich diese entlang der Richtung der ersten Distanz erstrecken, gilt, dass die erste Länge die kürzeste Länge ist.

Eine weitere Ausgestaltung der Erfindung weist eine dritte Distanz, die sich zwischen dem Domänenwandleiter und der Skala erstreckt, eine dritte Länge auf. Die erste Länge der ersten Distanz zwischen der Skala und der Detektoreinheit ist kleiner als die dritte Länge oder zumindest gleich der dritten Länge.

Ein Domänenwandspeicher umfasst ein insbesondere ebenes Substrat und der Domänenwandleiter ist als eine Leiterbahn auf dem Substrat ausgestaltet. In diesem Fall ist die Fläche, in welcher der Domänenwandleiter verläuft, eben. Alternativ könnte die Fläche auch gekrümmt ausgestaltet sein, insbesondere wenn der Domänenwandleiter Magneten mit einer gekrümmten Oberfläche gegenüber liegt.

Die Strukturbreite des Domänenwandleiters beträgt üblicherweise weniger als 500 nm häufig weniger als 300 nm, und die Dicke beziehungsweise Schichtdicke des Domänenwandleiters beträgt weniger als 60 nm. Der Domänenwandspeicher kann mehrere Domänenwandleiter aufweisen.

Der Domänenwandspeicher weist weiterhin Ausleseelemente auf, durch die (an der jeweiligen Position der Ausleseelemente) der lokale Magnetisierungszustand des Domänenwandleiters bestimmbar ist. Durch die Ausleseelemente ist somit jeweils ein Magnetisierungszustand des Domänenwandleiters bestimmbar. Die Ausleseelemente sind bezüglich des Domänenwandleiters ortsfest angeordnet. Als Ausleseelemente kommen beispielsweise GMR- oder TMR-Sensoren in Betracht. Ein Domänenwandspeicher umfasst also den oder die Domänenwandleiter, das Substrat, Ausleseelemente und das Gehäuse.

Gemäß einer weiteren Ausführungsform der Erfindung sind die erste Leiterplatte und die zweite Leiterplatte jeweils mehrlagig ausgeführt, so dass diese mehrere elektrisch leitfähige Lagen umfassen. Der Lagenaufbau der ersten Leiterplatte kann sich dabei vom Lagenaufbau der zweiten Leiterplatte unterscheiden. Die erste Leiterplatte und die zweite Leiterplatte können insbesondere unterschiedliche Anzahlen von Lagen aufweisen. Beispielsweise können sich aber auch die Dicken der elektrisch leitenden Lagen der ersten Leiterplatte von den Dicken der Lagen der zweiten Leiterplatte unterscheiden. Beispielhaft können die erste und die zweite Leiterplatte auch aus unterschiedlichen Materialien hergestellt sein. Andererseits kann eine der Leiterplatten einseitig und die andere der Leiterplatten beidseitig bestückt sein. Insbesondere können die erste und die zweite Leiterplatte so zueinander angeordnet sein, dass diese Oberflächen aufweisen, die in unterschiedlichen geometrischen Ebenen verlaufen, wobei die Leiterplatten insbesondere versetzt zueinander angeordnet sind.

Mit Vorteil ist die Positionsmesseinrichtung so ausgeführt, dass deren Wirkprinzip auf einem induktiven Messprinzip beruht, wobei die Detektoreinheit dann zumindest eine Empfängerleiterbahn aufweist.

Alternativ oder ergänzend kann auch ein magnetisches oder ein optisches Wirkprinzip zur Anwendung kommen. In letzterem Fall kann die Detektoreinheit an der ersten Leiterplatte eine Fotodiode oder ein Fotodiodenarray umfassen. Ebenso kann dann an der ersten Leiterplatte eine Lichtquelle, beispielsweise eine LED montiert sein. Die Skala würde dann im Falle einer Auflichtabtastung aus reflektierenden Skalenbereichen und nicht-reflektierenden Skalenbereichen bestehen. Alternativ könnte auch ein Durchlichtverfahren zur Anwendung kommen, bei der die Skala aus opaken und transparenten Skalenbereichen besteht und die Lichtquelle dann nicht an der ersten Leiterplatte montiert ist.

Vorteilhafterweise ist die Positionsmesseinrichtung als eine Winkelmesseinrichtung ausgestaltet, so dass die Messrichtung einer Umfangsrichtung entspricht.

In weiterer Ausgestaltung der Erfindung ist die erste Leiterplatte ringsegmentartig, insbesondere hufeisenförmig, ausgestaltet und erstreckt sich in Messrichtung über einen Winkel von mindestens 180°, insbesondere über einen Winkel von mindestens 200°, insbesondere über einen Winkel von mindestens 270°.

Auch die zweite Leiterplatte kann dann ringsegmentartig ausgestaltet sein. Diese erstreckt sich in Messrichtung über einen Winkel von weniger als 180°, insbesondere über einen Winkel von weniger als 120°, insbesondere über einen Winkel von weniger als 90°.

Mit Vorteil umfasst das Material des zumindest einen Magnets Kunststoff mit einem magnetisierbaren Füllstoff. Insbesondere kann zumindest einer der Magnete durch ein Pressverfahren oder Spritzgussverfahren hergestellt sein.

Vorteilhafterweise sind die erste Bauteilgruppe und die zweite Bauteilgruppe um eine Achse relativ zueinander drehbar angeordnet und die Fläche, in welcher der Domänenwandleiter verläuft, wird nicht von der Achse geschnitten beziehungsweise durchdrungen.

Der Domänenwandleiter liegt also radial versetzt zur Achse, diese Konfiguration wird häufig auch als Off-Axis-Anordnung bezeichnet.

In weiterer Ausgestaltung der Erfindung umfasst die zweite Bauteilgruppe mindestens zwei Magnete, die in Messrichtung aneinandergereiht sind. Mit Vorteil umfasst die zweite Bauteilgruppe zwei Magnete, die identisch ausgestaltet sind.

Mit Vorteil sind die in Messrichtung aneinandergereihten Magnete so magnetisiert, dass deren Magnetisierungsrichtungen mit orthogonaler Richtungskomponente zur Fläche, in welcher der Domänenwandleiter verläuft, verlaufen. Außerdem sind die Magnete so angeordnet, dass diese entgegengesetzte Magnetisierungsrichtungen aufweisen. Die Magnete sind zudem so angeordnet und ausgestaltet, dass der Abstand in Messrichtung zwischen dem ersten Magnet und dem zweiten Magnet entlang einer zweiten Richtung, die orthogonal zur Messrichtung orientiert ist, unterschiedlich groß ist. Die Fläche, in welcher der Domänenwandleiter verläuft, erstreckt sich einerseits entlang der Messrichtung und anderseits entlang der zweiten Richtung. Der Normalenvektor auf der Fläche ist in der dritten Richtung orientiert. Mit anderen Worten ist die Messrichtung orthogonal zur zweiten Richtung und orthogonal zur dritten Richtung orientiert.

Zwischen dem ersten Magnet und dem zweiten Magnet liegt also ein Spalt vor, der sich in Messrichtung erstreckt und dessen Länge in Messrichtung entlang der zweiten Richtung unterschiedlich groß ist. Die in Messrichtung gegenüber liegenden Konturen der Enden der Magneten sind insbesondere so ausgestaltet, dass diese, zumindest über einen sich in der zweiten Richtung erstreckenden Bereich, divergieren.

Vorteilhafterweise sind die Magnete in Messrichtung so aneinandergereiht angeordnet, dass sich diese nicht berühren. Folglich ist also in Messrichtung der minimale Abstand zwischen dem ersten Magnet und dem zweiten Magnet größer als Null.

Bedingt durch die Tatsache, dass zwischen dem ersten und dem zweiten Magneten in Messrichtung ein Abstand vorliegt, existiert in diesem Bereich ein Zwischenraum, der entweder aus Luft besteht, oder aber durch weitgehend unmagnetisches Material ausgefüllt ist.

Als Magnetisierungsrichtung kann die Richtung einer Verbindungslinie zwischen dem Nordpol und dem Südpol eines Magneten verstanden werden. Die Magnete sind vorzugsweise durch die Dicke magnetisiert.

In weiterer Ausgestaltung der Erfindung ist zumindest einer der Magnete so ausgestaltet, dass dieser bezüglich einer Linie, die parallel zur Messrichtung und orthogonal zur Magnetisierungsrichtung verläuft, eine asymmetrische Form aufweist. Diese Asymmetrie kann insbesondere durch eine asymmetrische Ausgestaltung zumindest eines Endes eines Magneten erreicht werden.

Mit Vorteil ist zumindest einer der Magnete an seinem Ende so ausgestaltet, dass dessen Kontur gekrümmt verläuft.

Bei einer als Winkelmesseinrichtung ausgestalteten Positionsmesseinrichtung verläuft die zweite Richtung entweder in radialer Richtung oder in axialer Richtung (Trommelanordnung) und die Messrichtung entspricht der Umfangsbeziehungsweise Tangentialrichtung. Auch bei dieser Konstellation ist die zweite Richtung stets orthogonal zur Messrichtung orientiert. Zudem verläuft die zweite Richtung orthogonal zur Magnetisierungsrichtung.

Die hier beschriebenen geometrischen Betrachtungen gelten für den räumlichen Bereich, in dem der betreffende Magnet dem Domänenwandleiter gegenüber liegt, sozusagen "aus Sicht" des Domänenwandleiters. Beispielsweise verlaufen ausgehend vom Domänenwandleiter die Magnetisierungsrichtungen orthogonal zur Fläche des Domänenwandleiters, auch wenn die Magnete rotieren.

Zwischen dem Domänenwandleiter und den Magneten liegt eine vierte Distanz mit einer vierten Länge vor. Die vierte Länge beziehungsweise die vierte Distanz erstreckt sich orthogonal zu der Fläche, in welcher der Domänenwandleiter verläuft (also in der dritten Richtung), wobei der minimale Abstand in Messrichtung zwischen den Magneten kleiner ist als die halbe vierte Länge. Für den Fall, dass die vierte Länge nicht über der gesamten Fläche des Domänenwandleiters hinweg gleich groß sein sollte, gilt insbesondere, dass der minimale Abstand zwischen den Magneten kleiner ist als die Hälfte der kleinsten vierten Länge.

Vorteilhafterweise ist der Domänenwandleiter bezüglich der zweiten Richtung so positioniert, dass dieser von den Magneten im Bereich eines Abstands zwischen den Magneten passiert wird, der kleiner ist als der maximale Abstand. Bei einer Vorbeifahrt der Magnete am Domänenwandleiter, befindet sich der Domänenwandleiter im Bereich des vergleichsweisen kleinen Abstands der Magnete und wird von den dort vorliegenden Magnetfeldlinien beeinflusst. Insbesondere ist der Domänenwandleiter bezüglich der zweiten Richtung so positioniert, dass dieser von den Magneten im Bereich des geringsten Abstands passiert wird. Bei einer Vorbeifahrt der Magnete am Domänenwandleiter, befindet sich dann der Domänenwandleiter im Bereich des geringsten Abstands der Magnete und wird von den dort vorliegenden Magnetfeldlinien beeinflusst.

Die Positionsmesseinrichtung kann als Winkelmesseinrichtung verwendet werden, bei der insbesondere Umdrehungsanzahlen gespeichert werden. Alternativ kann die Positionsmesseinrichtung als Längenmessgerät mit einem linearen Maßstab ausgestaltet sein, zur Messung von linearen Verschiebungen. Der Maßstab kann insbesondere ein erstes Maßstabsteil und ein zweites Maßstabsteil umfassen. Das erste Maßstabsteil und das zweite Maßstabsteil können etwa entlang der Messrichtung aneinandergereiht angeordnet sein, so dass eine vergleichsweise große Messlänge erreichbar ist. In der Praxis können auch durchaus mehr als nur zwei Maßstabsteile aneinandergereiht angeordnet sein. Entlang der ersten Richtung zueinander versetzt sind dann Magnete vorgesehen. Durch den Domänenwandspeicher ist es möglich entsprechende Positionsinformationen zu speichern, so dass feststellbar ist welches der Maßstabsteile gerade abgetastet wird.

Vorteilhafte Ausbildungen der Erfindung entnimmt man den abhängigen Ansprüchen.

Weitere Einzelheiten und Vorteile der erfindungsgemäßen Positionsmesseinrichtung ergeben sich aus der nachfolgenden Beschreibung von Ausführungsbeispielen anhand der beiliegenden Figuren.

### KURZE BESCHREIBUNG DER ZEICHNUNGEN

Es zeigen die
- Figur 1: eine perspektivische Explosions-Ansicht einer Positionsmesseinrichtung gemäß einem ersten Ausführungsbeispiel,
- Figur 2: eine Draufsicht auf eine erste Bauteilgruppe der Positionsmesseinrichtung,
- Figur 3: eine Draufsicht auf eine zweite Bauteilgruppe der Positionsmesseinrichtung,
- Figur 4: eine Draufsicht auf zwei Magnete der zweiten Bauteilgruppe,
- Figur 5: eine Draufsicht auf einen Domänenwandleiter,
- Figur 6: eine Schnittansicht auf ein Detail der Positionsmesseinrichtung,
- Figur 7: eine Schnittansicht auf ein Detail der Positionsmesseinrichtung gemäß einem zweiten Ausführungsbeispiel.

### BESCHREIBUNG DER AUSFÜHRUNGSFORMEN

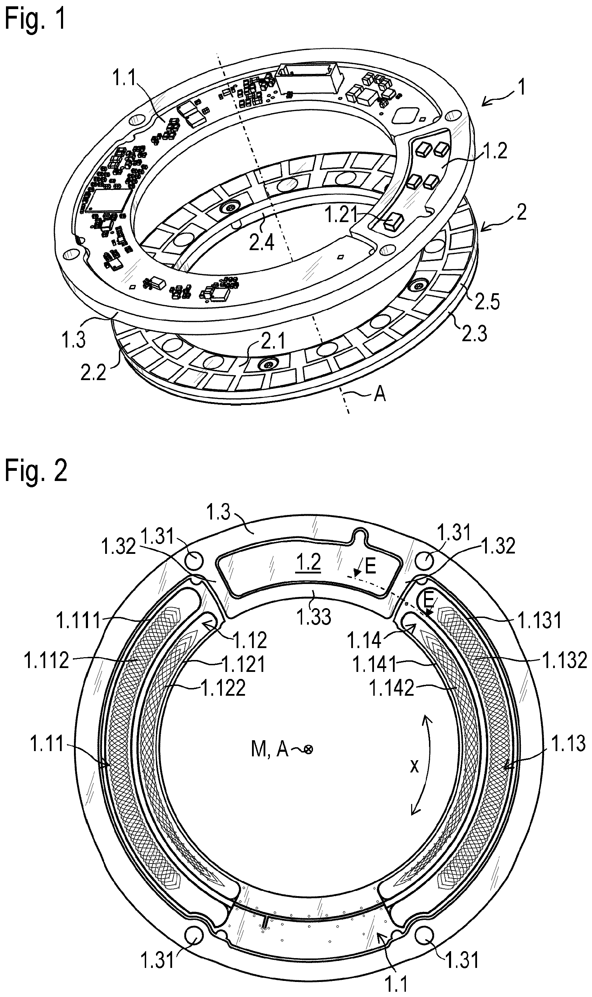

In der Figur 1 ist eine Positionsmesseinrichtung dargestellt, die eine erste Bauteilgruppe 1 und eine zweite Bauteilgruppe 2 umfasst, wobei die Bauteilgruppen 1, 2 relativ zueinander um eine Achse A drehbar angeordnet sind. Eine derartige Positionsmesseinrichtung dient als Winkelmesseinrichtung. Die Figur 1 ist eine perspektivische Explosionszeichnung, so dass der Abstand zwischen der ersten Bauteilgruppe 1 und der zweiten Bauteilgruppe 2 größer ist als dies im tatsächlichen Betrieb der Positionsmesseinrichtung der Fall ist.

Die erste Bauteilgruppe 1 umfasst eine erste Leiterplatte 1.1, welche mehrere Lagen aufweist, sowie elektronische Bauteile. Die erste Bauteilgruppe 1 umfasst zudem einen Rahmen 1.3 als mechanisch tragende Struktur.

Wie auch in der Figur 2 gezeigt, hat die erste Leiterplatte 1.1 die Form eines Kreisringsegments, das ca. über 300° umlaufend ausgestaltet ist und entsprechend eine Öffnung aufweist. Um die erste Leiterplatte 1.1 außen herum angeordnet ist der geschlossene und im wesentlichen ringförmige Rahmen 1.3, (hier aus Metall) befestigt, der insbesondere zur mechanischen Verstärkung der ersten Bauteilgruppe 1 dient und Befestigungsbereiche 1.31, hier in Form von Bohrungen, aufweist. Im Bereich der Öffnung der ersten Leiterplatte 1.1 verlaufen parallel zu den Stirnseiten der ersten Leiterplatte 1.1 im Wesentlichen in radialer Richtung Stege 1.32 des Rahmens 1.3. Ein weiterer Steg 1.33 des Rahmens 1.3 verläuft über einen Winkel von etwa 60° in einer Kreissegmentkontur.

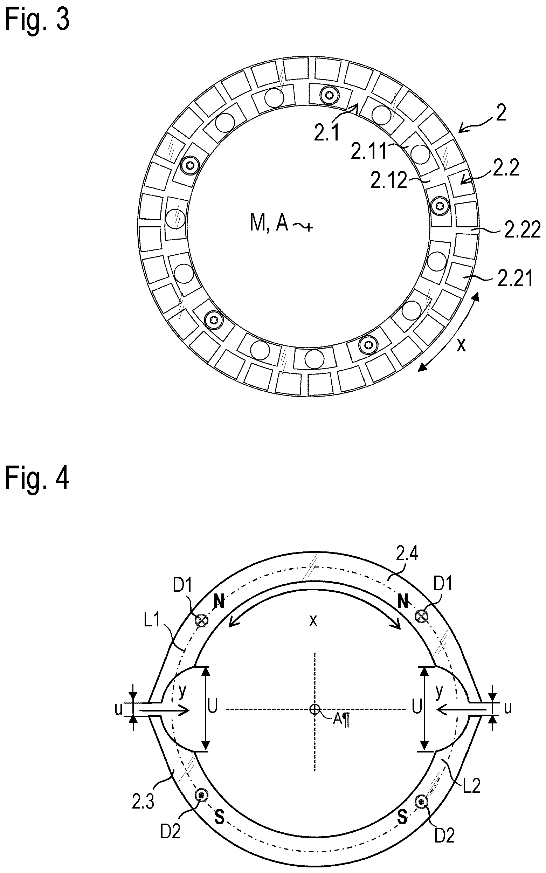

Die zweite Bauteilgruppe 2 weist gemäß dem Ausführungsbeispiel eine in erster Näherung ringförmige Gestalt auf (siehe Figuren 1 und 3). Die umfasst stirnseitig eine erste Skala 2.1 und eine zweite Skala 2.2, wobei sich die Skalen 2.1, 2.2 in einer Messrichtung x erstrecken.

Die Skalen 2.1, 2.2 sind hier auf einem Substrat 2.5 aufgebracht, welches im dargestellten Ausführungsbeispiel aus Leiterplattenmaterial hergestellt ist. Die Skalen 2.1, 2.2 sind ringförmig ausgebildet und bezüglich der Achse A konzentrisch mit unterschiedlichen Radien auf dem Substrat 2.5 angeordnet.

Gemäß der Figur 3 umfassen die Skalen 2.1, 2.2 Teilungsstrukturen bestehend aus jeweils einer periodischen Abfolge von entlang der Messrichtung x beziehungsweise Umfangsrichtung alternierend angeordneten elektrisch leitfähigen Teilungsbereichen 2.11, 2.21 und nichtleitfähigen Teilungsbereichen 2.12, 2.22, wobei die elektrisch leitfähigen Teilungsbereiche 2.11, 2.21, jeweils aus einer Schicht aus elektrisch leitfähigem Material gebildet sind. Als Material für die elektrisch leitfähigen Teilungsbereiche 2.11, 2.21 wurde im gezeigten Beispiel Kupfer auf das Substrat 2.5 aufgebracht. In den nichtleitfähigen Teilungsbereichen 2.12, 2.22 ist das Substrat 2.5 dagegen nicht beschichtet. Durch die Anordnung mit jeweils zwei Skalen 2.1, 2.2 kann die Winkelstellung der zweiten Bauteilgruppe 2 absolut bestimmt werden. Die äußere zweite Skala 2.2 weist die größere Anzahl von jeweiligen Teilungsbereichen 2.21, 2.22 entlang der Umfangsrichtung x auf, so dass durch diese die größere Auflösung bezüglich der Messung der Winkelstellung erzielbar ist.

Außerdem sind auf derjenigen Seite des Substrats 2.5, die den Skalen 2.1, 2.2 gegenüber liegt, ein erster Magnet 2.3 und ein zweiter Magnet 2.4 angeordnet, wobei die Magnete 2.3, 2.4 der zweiten Bauteilgruppe 2 zugeordnet sind. Die Magnete 2.3, 2.4 und das Substrat 2.5 sind also jeweils fest miteinander verbunden und bewegen sich mit der gleichen Geschwindigkeit beziehungsweise Drehzahl wie die Skalen 2.1, 2.2. Die Magnete 2.3, 2.4 sind in der Messrichtung x, die hier der Umfangsrichtung entspricht, aneinandergereiht angeordnet und weisen jeweils eine sich in Messrichtung x erstreckende Mittelinie L1, L2 auf (siehe auch die Figur 4).

Im vorgestellten Ausführungsbeispiel sind die Magnete 2.3, 2.4 als kunststoffgebundene Magnete ausgestaltet. Entsprechend umfassen diese Kunststoff mit einem magnetisierbaren Füllstoff, beziehungsweise Magnetpulver. Der Füllstoff ist in einer Kunststoffmatrix eingebettet. Insbesondere können die Magnete 2.3, 2.4 als gepresste Magnete ausgeführt sein, wobei der magnetisierbare Füllstoff in einer duroplastischen Kunststoffmatrix, z. B. Epoxidharz, eingebettet ist. Alternativ können die Magnete 2.3, 2.4 auch in einem Spritzgussverfahren hergestellt werden.

Die Magnete 2.3, 2.4 sind so angeordnet, dass diese entgegensetzte Magnetisierungsrichtungen D1, D2 aufweisen. Zudem sind die Magnete 2.3, 2.4 als Permanentmagnete ausgestaltet und jeweils durch die Dicke magnetisiert, also so, dass deren Magnetisierungsrichtungen D1, D2 hier axial orientiert sind. Die Magnete 2.3, 2.4 weisen entgegensetzte Magnetisierungsrichtungen D1, D2 auf. Im vorgestellten Ausführungsbeispiel sind beide Magnete 2.3, 2.4 identisch, was für die Montage und Lagerhaltung vorteilhaft ist.

Die Enden der Magnete 2.3, 2.4 sind so ausgestaltet, dass sich diese verjüngen. Demnach sind der erste Magnet 2.3 und der zweite Magnet 2.4 so ausgestaltet, dass sich der in Messrichtung x erstreckende Abstand u, U zwischen dem ersten Magnet 2.3 und dem zweiten Magnet 2.4 verändert, wenn man diesen an verschiedenen Stellen entlang einer zweiten Richtung y ermittelt. In der Figur 4 vergrößert sich der Abstand u, U, entlang der zweiten Richtung y dem Pfeil folgend. Die zweite Richtung y verläuft orthogonal zur Messrichtung x, also hier radial zur Achse A beziehungsweise in radialer Richtung. Somit ist der Abstand u, U entlang der zweiten Richtung y beziehungsweise in Abhängigkeit von einer Position entlang der zweiten Richtung y unterschiedlich groß. Die Konturen der einander gegenüber liegenden Enden der Magnete 2.3, 2.4 sind spiegelsymmetrisch ausgestaltet, bezogen auf eine Symmetrieachse, die parallel zur zweiten Richtung y orientiert ist. Zudem sind die Enden der Magnete 2.3, 2.4 so ausgestaltet, dass deren Konturen bezüglich einer Linie die parallel zur Messrichtung x orientiert ist, insbesondere bezüglich der Mittelinie L1, L2, asymmetrisch verlaufen. Im Bereich, in dem sich der Abstand u, U in Messrichtung x zwischen den Magneten 2.3, 2.4 verändert, sind der erste Magnet 2.3 und der zweite Magnet 2.4 beziehungsweise deren Konturen so ausgestaltet, dass sich dieser Abstand u, U entlang der zweiten Richtung y stetig verändert, das heißt, dass die Konturen dort entlang der zweiten Richtung y als glatte Kurven und ohne einen Sprung ausgebildet sind.

Zur Bestimmung der Winkelinformationen weist gemäß der Figur 2 die erste Leiterplatte 1.1 eine erste Detektoreinheit 1.11, eine zweite Detektoreinheit 1.12, eine dritte Detektoreinheit 1.13 und eine vierte Detektoreinheit 1.14 auf. Die Detektoreinheiten 1.11 bis 1.14 haben jeweils eine ringsegmentartige Form, wobei für alle Detektoreinheiten 1.11 bis 1.14 gilt, dass der Mittelpunkt M der jeweiligen ringsegmentartigen Form auf der Achse A liegt. Demnach liegen die Detektoreinheiten 1.11 bis 1.14 bezüglich des Mittelpunkts M in erster Näherung konzentrisch einander gegenüber.

Die erste Detektoreinheit 1.11 umfasst eine erste Erregerspur 1.111 und erste Empfängerleiterbahnen 1.112. Ebenso umfassen die zweite Detektoreinheit 1.12 eine zweite Erregerspur 1.121 und zweite Empfängerleiterbahnen 1.122, die dritte Detektoreinheit 1.13 eine dritte Erregerspur 1.131 und dritte Empfängerleiterbahnen 1.132 sowie die vierte Detektoreinheit 1.14 eine vierte Erregerspur 1.141 und vierte Empfängerleiterbahnen 1.142.

Die Erregerspuren 1.111, 1.121, 1.131, 1.141 umschließen jeweils zugehörige Empfängerleiterbahnen 1.112, 1.122, 1.132, 1.142. Sowohl die Erregerspuren 1.111, 1.121, 1.131, 1.141, als auch die Empfängerleiterbahnen 1.112, 1.122, 1.132, 1.142 verlaufen entlang der Messrichtung x.

Jede Detektoreinheit 1.11, 1.12, 1.13, 1.14 umfasst im vorgestellten Ausführungsbeispiel jeweils vier Empfängerleiterbahnen 1.112, 1.122, 1.132, 1.142, die in Messrichtung x beziehungsweise Umfangsrichtung versetzt angeordnet sind, so dass diese dem Versatz entsprechend vier phasenverschobene Signale liefern können. Im vorgestellten Ausführungsbeispiel sind innerhalb einer Detektoreinheit 1.11, 1.12, 1.13, 1.14 benachbarte Empfängerleiterbahnen 1.112, 1.122, 1.132, 1.142 um 1/8 der vollen Sinusperiode (um π/4 oder 45° entlang der Umfangsrichtung x) zueinander versetzt angeordnet.

In der Figur 2 sind diejenigen Empfängerleiterbahnen 1.112, 1.122, 1.132, 1.142, welche ein und derselben Detektoreinheit 1.11, 1.12, 1.13, 1.14 angehören, mit nur einem Bezugszeichen versehen. Zudem verlaufen die Empfängerleiterbahnen 1.112, 1.122, 1.132, 1.142 der Detektoreinheiten 1.11 bis 1.14 mit Vias verbunden in unterschiedlichen Lagen der ersten Leiterplatte 1.1, so dass an Kreuzungspunkten unerwünschte Kurzschlüsse vermieden werden. Wenngleich genau genommen jede der Empfängerleiterbahnen 1.112, 1.122, 1.132, 1.142 aus vielen Leiterstücken besteht, die jeweils auf zwei Ebenen beziehungsweise Lagen verteilt und aneinandergereiht sind, wird im Folgenden eine derartige Struktur zusammenfassend als eine Empfängerleiterbahn 1.112, 1.122, 1.132, 1.142 bezeichnet.

Die Empfängerleiterbahnen 1.112, 1.122, 1.132, 1.142 einer Detektoreinheit 1.11, 1.12, 1.13, 1.14 sind elektrisch so verschaltet, dass diese zum einen 0° und 90°-Signale liefern und zum anderen 45° und 135°-Signale. Aus den 0° und 90°-Signalen kann ein erstes Positionssignal bestimmt werden und aus den 45° und 135°-Signalen kann ein bezüglich des ersten Positionssignals redundantes zweites Positionssignal bestimmt werden.

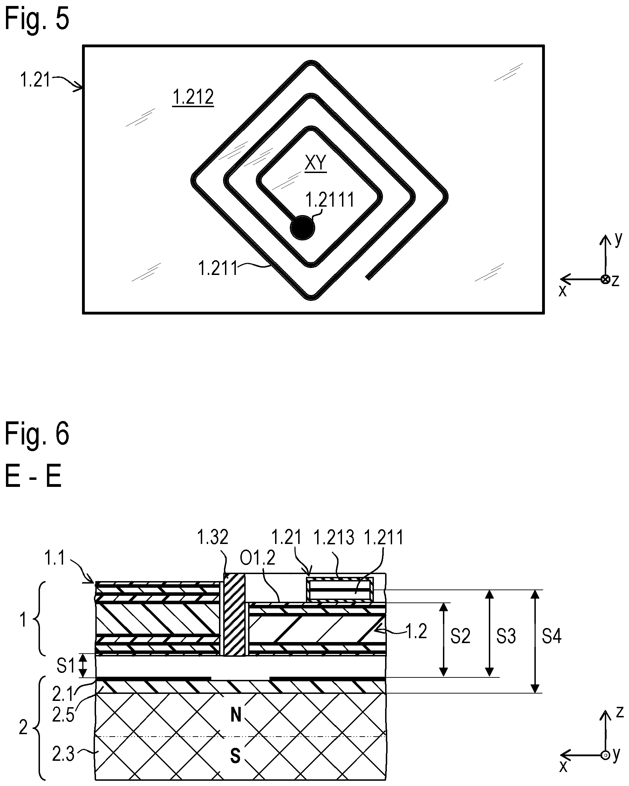

Weiterhin umfasst die erste Bauteilgruppe 1 die zweite Leiterplatte 1.2, die ringsegmentartig ausgestaltet ist und sich im vorgestellten Ausführungsbeispiel über einen Winkel von etwa 52° erstreckt. Auf der zweiten Leiterplatte 1.2 ist der Domänenwandspeicher 1.21 montiert. Der Domänenwandspeicher 1.21 umfasst gemäß der Figur 5 einen Domänenwandleiter 1.211 und ein Substrat 1.212, wobei der Domänenwandleiter 1.211 in Form einer Leiterbahn auf dem Substrat 1.212 aufgebracht ist und in (beziehungsweise auf) einer ersten Fläche XY verläuft. Der Domänenwandleiter 1.211 weist an einem Ende einen Domänenwandgenerator 1.2111 auf. Im vorgestellten Ausführungsbeispiel weist das Substrat 1.212 eine mechanisch tragende Siliziumschicht auf, wobei das Substrat 1.212 eben ausgestaltet ist und der Domänenwandleiter 1.211 ein Teil eines CMOS-Chips sein kann. Alternativ kann das Substrat eine Glasschicht aufweisen. Der Domänenwandleiter 1.211 umfasst ein weichmagnetisches Material beispielsweise eine Ni-Fe-Legierung. Der Domänenwandleiter 1.211 kann wie in der Figur 5 dargestellt als eine offene Spirale ausgestaltet sein oder einen geschlossenen Verlauf aufweisen.

Im Betrieb der Positionsmesseinrichtung liegen die erste Bauteilgruppe 1 und die zweite Bauteilgruppe 2 einander gegenüber. Im vorgestellten Ausführungsbeispiel kann die erste Bauteilgruppe 1 als Stator und die zweite Bauteilgruppe 2 als Rotor betrieben werden. Die erste Leiterplatte 1.1 dient zur Abtastung der Skalen 2.1, 2.2. Im vorgestellten Ausführungsbeispiel sind die elektronischen Bauteile nur auf einer Seite der ersten Leiterplatte 1.1 montiert, nämlich auf der von den Skalen 2.1, 2.2 abgewandten Seite. Der Domänenwandspeicher 1.21 wird zur Gewährleistung einer Multiturn-Funktionalität, also das Zählen von vielen Umdrehungen beziehungsweise Durchläufen, verwendet. Der Domänenwandspeicher 1.21 ist so angeordnet, dass die Fläche XY, in welcher der Domänenwandleiter 1.211 verläuft (beziehungsweise angeordnet ist), orthogonal zur Magnetisierungsrichtung D1, D2 orientiert ist.

In der Figur 6 ist eine Teilschnittdarstellung (E -E siehe Figur 2) durch die erste Bauteilgruppe 1 und die zweite Bauteilgruppe 2 gezeigt. Insgesamt weist die erste Leiterplatte 1.1 hier sechs elektrisch leitfähige Lagen auf. Die erste Leiterplatte 1.1 kann getrennt durch eine gedachte Ebene, die sich in der x,y-Richtung erstreckt, in zwei Hälften getrennt werden. Die elektrisch leitfähigen Lagen, die sich in derjenigen Hälfte der ersten Leiterplatte 1.1 befinden, die den Skalen 2.1, 2.2 zugewandt ist (in der Figur 6 in der unteren Hälfte) sind so strukturiert, dass diese die Detektoreinheiten 1.11 bis 1.14 bilden. Dagegen dienen die drei anderen, in der Figur 6 in der oberen Hälfte der ersten Leiterplatte 1.1 befindlichen, elektrisch leitfähigen Lagen zur Verbindung der elektronischen Bauteile der elektrischen Schaltung.

Die zweite Leiterplatte 1.2 kann einfacher aufgebaut sein und weist im vorgestellten Ausführungsbeispiel nur vier elektrisch leitfähige Lagen auf. Diese dienen zur Verbindung der elektronischen Bauteile der elektrischen Schaltung, die letztlich zur Zählung der Umdrehungen beziehungsweise Durchläufe verwendet wird. Der Domänenwandspeicher 1.21 weist ein Gehäuse 1.213 mit elektrischen Anschlussstellen auf, in dem der Domänenwandleiter 1.211 samt Substrat 1.212 angeordnet ist. Das Gehäuse 1.213 ist auf einer ersten Oberfläche 01.2 der zweiten Leiterplatte 1.2 montiert.

Damit die zweite Leiterplatte 1.2 im Zuge der Montage der ersten Bauteilgruppe 1 auf einfache Weise genau positioniert werden kann, weisen der Rahmen 1.3 und die zweite Leiterplatte 1.2 geeignete Führungsflächen auf.

Zwischen den Bauteilgruppen 1, 2 befindet sich ein Luftspalt, der sich in einer dritten Richtung z erstreckt. Eine erste Distanz erstreckt sich in der dritten Richtung z zwischen der Skala 2.1 und derjenigen Lage der ersten Leiterplatte 1.1, die der Skala 2.1 am nächsten liegt und in welcher zumindest Teile der Detektoreinheit 1.11, 1.12, 1.13, 1.14 insbesondere Abschnitte der Empfängerleiterbahnen 1.112, 1.122, 1.132, 1.142 angeordnet sind. Diese erste Distanz weist eine Länge S1 auf. Eine zweite Distanz, die sich zwischen der Skala 2.1 und der ersten Oberfläche O1.2 erstreckt, weist eine zweite Länge S2 auf. Dabei ist die erste Länge S1 kleiner als die zweite Länge S2, so dass die Bedingung S1 ≤ S2 erfüllt ist. Weiterhin weist eine dritte Distanz, die sich zwischen dem Domänenwandleiter 1.211 und der Skala 2.1 erstreckt eine dritte Länge S3 auf, wobei hier die erste Länge S1 kleiner als die dritte Länge S3 ist, weshalb auch hier das Kriterium S1 ≤ S3 erfüllt ist.

Im zusammengebauten Zustand stehen sich also die Detektoreinheiten 1.11, 1.12, 1.13, 1.14 und die Skalen 2.1, 2.2 mit axialem Abstand beziehungsweise Spalt gegenüber, so dass bei einer Relativdrehung zwischen der ersten Bauteilgruppe 1 und der zweiten Bauteilgruppe 2 in den Empfängerleiterbahnen 1.112, 1.122, 1.132, 1.142 jeweils ein von der jeweiligen Winkelposition abhängiges Signal durch Induktionseffekte erzeugbar ist. Voraussetzung für die Bildung von entsprechenden Signalen ist, dass die Erregerspuren 1.111, 1.121, 1.131, 1.141 ein zeitlich wechselndes elektromagnetisches Erregerfeld im Bereich der jeweilig abgetasteten Teilungsstrukturen erzeugen. Im dargestellten Ausführungsbeispiel sind die Erregerspuren 1.111, 1.121, 1.131, 1.141 als mehrere planar-parallele stromdurchflossene Einzel-Leiterbahnen ausgebildet. Die erste Leiterplatte 1.1 weist eine elektronische Schaltung mit den elektronischen Bauteilen auf, die miteinander elektrisch verbunden sind. Die elektronische Schaltung kann beispielsweise auch einen ASIC-Baustein umfassen. Die Signale, die von den Empfängerleiterbahnen 1.112, 1.122, 1.132, 1.142 erzeugt werden, werden mit Hilfe von einigen der elektronischen Bauteile, die eine Auswerteschaltung bilden, weiterverarbeitet. Diese elektronische Schaltung des Abtastelements 1 arbeitet nicht nur als Auswerteelement, sondern auch als Erregerkontrollelement, unter dessen Kontrolle der Erregerstrom generiert beziehungsweise erzeugt wird, welcher dann durch die Erregerspuren 1.111, 1.121, 1.131, 1.141 fließt. Somit werden die Erregerspuren 1.111, 1.121, 1.131, 1.141 durch ein und dasselbe Erregerkontrollelement bestromt.

Werden die Erregerspuren 1.111, 1.121, 1.131, 1.141 bestromt, so bildet sich um die Erregerspuren 1.111, 1.121, 1.131, 1.141 ein schlauch- bzw. zylinderförmig orientiertes elektromagnetisches Feld aus. Die Feldlinien des resultierenden elektromagnetischen Feldes verlaufen um die Erregerspuren 1.111, 1.121, 1.131, 1.141, wobei die Richtung der Feldlinien in bekannter Art und Weise von der Stromrichtung in den Erregerspuren 1.111, 1.121, 1.131, 1.141 abhängt. Im Bereich der elektrisch leitfähigen Teilungsbereiche 2.11, 2.21 werden Wirbelströme induziert, so dass jeweils eine von der Winkelstellung abhängige Modulation des Feldes erreicht wird. Entsprechend kann durch die Empfängerleiterbahnen 1.112, 1.122, 1.132, 1.142 jeweils die relative Winkelstellung gemessen werden.

Wenn ein relativ zum Domänenwandleiter 1.211 bewegtes Magnetfeld geeignet auf den Domänenwandleiter 1.211 einwirkt, verschieben sich Domänenwände innerhalb beziehungsweise entlang des Domänenwandleiters 1.2111. Zur Bildung eines optimierten Magnetfeldes wird eine Magnetanordnung verwendet, wie sie oben beschrieben ist mit den Magneten 2.3, 2.4, die an den jeweiligen einander gegenüber liegenden Enden der Magnete 2.3, 2.4 Verjüngungen aufweisen. Es hat sich als überaus vorteilhaft herausgestellt, wenn wie im Ausführungsbeispiel die jeweilige Kontur eines Endes eines Magnets 2.3, 2.4 gekrümmt verläuft, so dass die Magnete 2.3, 2.4 jeweils an ihren Enden einen konkaven Abschnitt aufweisen. Zur Vergleichmäßigung des Magnetfelds im Bereich des Übergangs vom ersten Magnet 2.3 zum zweiten Magnet 2.4 ist hier der minimale Abstand u größer als Null gewählt. Der minimale Abstand u zwischen dem ersten und dem zweiten Magnet 2.3, 2.4 ist zudem so dimensioniert, dass dieser kleiner ist als die halbe Länge S4 der vierten Distanz zwischen Domänenwandleiter 1.211 und den Magneten 2.3, 2.4 (u < ½ S4).

Der Domänenwandleiter 1.211 ist bezüglich der zweiten Richtung y so positioniert, dass dieser von den Magneten 2.3, 2.4 im Bereich des geringsten Abstands u passiert wird. Wenn sich nun die Magnete 2.3, 2.4 in der Messrichtung x relativ zum Domänenwandleiter 1.211 bewegen, wirkt auf den Domänenwandleiter 1.211 an den Enden und insbesondere im Bereich des Spalts zwischen den Magneten 2.3, 2.4 ein Magnetfeld, das in der Ebene des Domänenwandleiters 1.2111, also in der Fläche XY, quasi rotierend ist. Infolgedessen verschieben sich die Positionen von Domänenwänden, wobei das Verschiebefeld dadurch erzeugt wird, dass die Magnete 2.3, 2.4 am Domänenwandleiter 1.211 vorbeigeführt werden.

Nach jeder Vorbeifahrt der Enden der Magnete 2.3, 2.4 am Domänenwandleiter 1.211 beziehungsweise nach jeder halben Umdrehung der zweiten Bauteilgruppe 2 bewegt sich die Domänenwand, beziehungsweise bewegen sich die Domänenwände, weiter.

Die Magnetisierungsrichtungen innerhalb von Abschnitten des Domänenwandleiters 1.2111 und damit die Positionen der Domänenwände können durch die im Domänenwandspeicher 1.21 integrierten Ausleseelemente detektiert werden. Auf diese Weise ist eine Zählung von Umdrehungen beziehungsweise eine Speicherung der Umdrehungsinformation in einer Winkelmesseinrichtung möglich, auch wenn keine Hilfsenergie nutzbar ist. Dies ist beispielsweise wichtig, wenn bei einem Stromausfall eine Welle etwa durch Gewichtsbelastung bewegt wird. Die Domänenwände werden im Übrigen drehrichtungsabhängig verschoben, so dass der Domänenwandspeicher 1.21 zuverlässig bei Anwendungen eingesetzt werden kann, die beide Drehrichtungen zulassen.

Aus der Abtastung der Skalen 2.1, 2.2 durch die Detektoreinheiten 1.11, 1.12, 1.13, 1.14 resultiert eine vergleichsweise genaue Bestimmung der Winkelposition innerhalb einer Umdrehung. Zur absoluten Bestimmung der Winkelposition über mehrere Umdrehungen hinweg müssen die mit der Abtasteinrichtung 1.12 ermittelte Winkelposition (Feinposition) mit der Umdrehungsinformation (Grobposition) des Domänenwandleiters 1.211 synchronisiert werden.

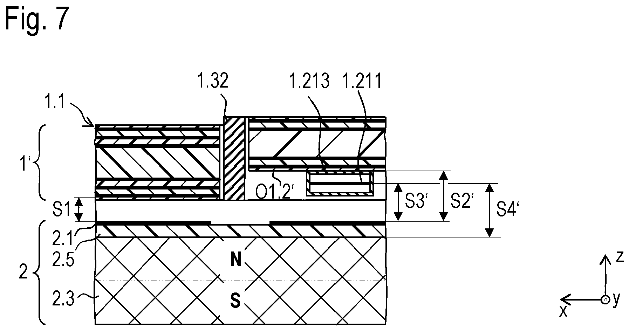

In der Figur 7 ist ein zweites Ausführungsbeispiel gezeigt. Dieses unterscheidet sich vom ersten Ausführungsbeispiel im Wesentlichen dadurch, dass die erste Oberfläche O1.2' der zweiten Leiterplatte 1.2 nun den Skalen 2.1, 2.2 zugewandt angeordnet ist.

Das Gehäuse 1.213 ist auf der ersten Oberfläche O1.2' der zweiten Leiterplatte 1.2 montiert. Dementsprechend weist im zweiten Ausführungsbeispiel die erste Distanz unverändert die Länge S1 auf. Dagegen weist die zweite Distanz, die sich zwischen der Skala 2.1 und der ersten Oberfläche O1.2' erstreckt, die zweite Länge S2' auf, die hier kürzer ist als die zweite Länge S2 gemäß dem ersten Ausführungsbeispiel. Dennoch gilt auch im zweiten Ausführungsbeispiel, dass die erste Länge S1 kleiner ist als die zweite Länge S2', somit ist das Kriterium (S1 ≤ S2') erfüllt. Weiterhin weist die dritte Distanz, die sich zwischen dem Domänenwandleiter 1.211 und der Skala 2.1 erstreckt die dritte Länge S3' auf. Auch im zweiten Ausführungsbeispiel gilt, dass die erste Länge S1 kleiner ist als die dritte Länge S3' im Allgemeinen soll gelten S1 ≤ S3'.

Die Magnetanordnung gemäß der Figur 2 kann grundsätzlich auch für das zweite Ausführungsbeispiel verwendet werden. Es gilt daher auch hier, dass der minimale Abstand u zwischen dem ersten und dem zweiten Magnet 2.3, 2.4 so dimensioniert ist, dass dieser kleiner ist als die halbe Länge S4' der vierten Distanz zwischen dem Domänenwandleiter 1.211 und den Magneten 2.3, 2.4 (u < ½ S4').

## Patentansprüche

1. Positionsmesseinrichtung umfassend eine erste Bauteilgruppe (1; 1') und eine zweite Bauteilgruppe (2), wobei die Bauteilgruppen (1; 1', 2) in einer Messrichtung (x) relativ zueinander beweglich angeordnet sind, wobei
- die erste Bauteilgruppe (1; 1')
eine erste Leiterplatte (1.1) aufweist, die eine Detektoreinheit (1.11, 1.12, 1.13, 1.14) umfasst und
eine zweite Leiterplatte (1.2) aufweist, die einen Domänenwandleiter (1.211) umfasst, wobei
die erste Leiterplatte (1.1) in der Messrichtung (x) versetzt zur zweiten Leiterplatte (1.2) angeordnet ist und
- die zweite Bauteilgruppe (2)
eine Skala (2.1, 2.2) und
einen Magnet (2.3, 2.4) umfasst, wobei
die Skala (2.1, 2.2) zwischen dem Magnet (2.3, 2.4) und der zweiten Leiterplatte (1.2) angeordnet ist, wobei
zur Bestimmung der Relativposition in Messrichtung (x) die Skala (2.1, 2.2) von der Detektoreinheit (1.11, 1.12, 1.13, 1.14) abtastbar ist und der Magnet (2.3, 2.4) so ausgebildet und angeordnet ist, dass durch diesen eine Verschiebung einer Domänenwand im Domänenwandleiter (1.211) bei einer Vorbeifahrt des Magnets (2.3, 2.4) erzeugbar ist.

2. Positionsmesseinrichtung gemäß dem Anspruch 1, wobei der Domänenwandleiter (1.211) in einem Gehäuse (1.213) angeordnet ist, welches auf einer ersten Oberfläche (01.2; O1.2') der zweiten Leiterplatte (1.2) montiert ist, wobei
- eine erste Distanz zwischen der Skala (2.1, 2.2) und der Detektoreinheit (1.11, 1.12, 1.13, 1.14) eine erste Länge (S1) aufweist und
- eine zweite Distanz zwischen der ersten Oberfläche (01.2; O1.2') und der Skala (2.1, 2.2) eine zweite Länge (S2; S2') aufweist, wobei gilt, dass
die erste Länge (S1) kleiner oder gleich ist als die zweite Länge (S2; S2').

3. Positionsmesseinrichtung gemäß dem Anspruch 1 oder 2, wobei
- eine erste Distanz zwischen der Skala (2.1, 2.2) und der Detektoreinheit (1.11, 1.12, 1.13, 1.14) eine erste Länge (S1) aufweist und
- eine dritte Distanz zwischen dem Domänenwandleiter (1.211) und der Skala (2.1, 2.2) eine dritte Länge (S3; S3') aufweist, wobei gilt, dass
die erste Länge (S1) kleiner oder gleich ist als die dritte Länge (S3; S3').

4. Positionsmesseinrichtung gemäß einem der vorhergehenden Ansprüche, wobei die erste Leiterplatte (1.1) und die zweite Leiterplatte (1.2) jeweils mehrlagig ausgeführt sind, wobei sich der Lagenaufbau der ersten Leiterplatte (1.1) vom Lagenaufbau der zweiten Leiterplatte (1.2) unterscheidet.

5. Positionsmesseinrichtung gemäß einem der vorhergehenden Ansprüche, wobei die Positionsmesseinrichtung auf einem induktiven Messprinzip beruht und die Detektoreinheit (1.11, 1.12, 1.13, 1.14) zumindest eine Empfängerleiterbahn (1.112, 1.122, 1.132, 1.142) aufweist.

6. Positionsmesseinrichtung gemäß einem der vorhergehenden Ansprüche, wobei die Positionsmesseinrichtung als eine Winkelmesseinrichtung ausgestaltet ist.

7. Positionsmesseinrichtung gemäß dem Anspruch 6, wobei die erste Leiterplatte (1.1) ringsegmentartig ausgestaltet ist und sich über einen Winkel von mindestens 180° erstreckt.

8. Positionsmesseinrichtung gemäß dem Anspruch 6 oder 7, wobei die zweite Leiterplatte (1.2) ringsegmentartig ausgestaltet und sich über einen Winkel von weniger als 180° erstreckt.

9. Positionsmesseinrichtung gemäß einem der vorhergehenden Ansprüche, wobei das Material des Magnets (2.3, 2.4) Kunststoff mit einem magnetisierbaren Füllstoff umfasst.

10. Positionsmesseinrichtung gemäß einem der vorhergehenden Ansprüche, wobei die Bauteilgruppen (1; 1', 2) um eine Achse (A) relativ zueinander drehbar angeordnet sind und eine Fläche (XY), in welcher der Domänenwandleiter (1.211) verläuft, nicht von der Achse (A) geschnitten wird.

11. Positionsmesseinrichtung gemäß einem der vorhergehenden Ansprüche, wobei die zweite Bauteilgruppe (2) zwei Magnete (2.3, 2.4) umfasst.

12. Positionsmesseinrichtung gemäß dem Anspruch 11, wobei die Magnete (2.3, 2.4)
- in Messrichtung (x) aneinandergereiht angeordnet sind,
- so magnetisiert sind, dass deren Magnetisierungsrichtungen (D1, D2; D1', D2') mit orthogonaler Richtungskomponente zur Fläche (XY) verlaufen,
- so angeordnet sind, dass diese entgegensetzte Magnetisierungsrichtungen (D1, D2) aufweisen, wobei
die Magnete (2.3, 2.4) so angeordnet und ausgestaltet sind, dass
der Abstand (u, U) in Messrichtung (x) zwischen dem ersten Magnet (2.3) und dem zweiten Magnet (2.4) an verschiedenen Stellen entlang einer zweiten Richtung (y), die orthogonal zur Messrichtung (x) orientiert ist, unterschiedlich groß ist.

13. Positionsmesseinrichtung gemäß dem Anspruch 11 oder 12, wobei die Magnete (2.3, 2.4) in Messrichtung (x) so aneinandergereiht angeordnet sind, dass sich diese nicht berühren.

14. Positionsmesseinrichtung gemäß dem Anspruch 11, 12 oder 13, wobei sich zwischen dem Domänenwandleiter (1.211) und den Magneten (2.3, 2.4) eine vierte Distanz befindet, die sich orthogonal zu einer Fläche (XY) erstreckt, in welcher der Domänenwandleiter (1.211) verläuft,
wobei die vierte Distanz eine vierte Länge (S4; S4') aufweist, wobei der minimale Abstand (u) in Messrichtung (x) zwischen den Magneten (2.3, 2.4) kleiner ist als die halbe vierte Länge (S4; S4').

15. Positionsmesseinrichtung gemäß einem der Ansprüche 11 bis 14, wobei zumindest einer der Magnete (2.3, 2.4) an seinem Ende so ausgestaltet ist, dass dessen Kontur gekrümmt verläuft.

## Claims

1. Position measuring device comprising a first component group (1; 1') and a second component group (2), wherein the component groups (1; 1', 2) are arranged moveably relative to each other in a measuring direction (x), wherein
- the first component group (1; 1')
has a first printed circuit board (1.1) which comprises a detector unit (1.11, 1.12, 1.13, 1.14) and
has a second printed circuit board (1.2) which comprises a domain wall conductor (1.211), wherein
the first printed circuit board (1.1) is arranged offset from the second printed circuit board (1.2) in the measuring direction (x) and
- the second component group (2) comprises
a scale (2.1, 2.2) and
a magnet (2.3, 2.4), wherein
the scale (2.1, 2.2) is arranged between the magnet (2.3, 2.4) and the second printed circuit board (1.2), wherein, in order to determine the relative position in the measuring direction (x), the scale (2.1, 2.2) can be scanned by the detector unit (1.11, 1.12, 1.13, 1.14) and the magnet (2.3, 2.4) is formed and arranged such that this magnet can generate displacement of a domain wall in the domain wall conductor (1.211) when the magnet (2.3, 2.4) passes by.

2. Position measuring device according to Claim 1, wherein the domain wall conductor (1.211) is arranged in a housing (1.213) which is mounted on a first surface (O1.2; O1.2') of the second printed circuit board (1.2), wherein
- a first distance between the scale (2.1, 2.2) and the detector unit (1.11, 1.12, 1.13, 1.14) has a first length (S1) and
- a second distance between the first surface (O1.2; O1.2') and the scale (2.1, 2.2) has a second length (S2; S2'), where
the first length (S1) is less than or equal to the second length (S2; S2').

3. Position measuring device according to Claim 1 or 2, wherein
- a first distance between the scale (2.1, 2.2) and the detector unit (1.11, 1.12, 1.13, 1.14) has a first length (S1) and
- a third distance between the domain wall conductor (1.211) and the scale (2.1, 2.2) has a third length (S3; S3'), where
the first length (S1) is less than or equal to the third length (S3; S3').

4. Position measuring device according to any of the preceding claims, wherein the first printed circuit board (1.1) and the second printed circuit board (1.2) are each of multi-layered configuration, wherein the layer structure of the first printed circuit board (1.1) differs from the layer structure of the second printed circuit board (1.2).

5. Position measuring device according to any of the preceding claims, wherein the position measuring device is based on an inductive measuring principle and the detector unit (1.11, 1.12, 1.13, 1.14) has at least one receiver conductor track (1.112, 1.122, 1.132, 1.142).

6. Position measuring device according to any of the preceding claims, wherein the position measuring device is designed as an angle measuring device.

7. Position measuring device according to Claim 6, wherein the first printed circuit board (1.1) is designed in the form of a segment of a ring and extends over an angle of at least 180°.

8. Position measuring device according to Claim 6 or 7, wherein the second printed circuit board (1.2) is designed in the form of a segment of a ring and extends over an angle of less than 180°.

9. Position measuring device according to any of the preceding claims, wherein the material of the magnet (2.3, 2.4) comprises plastic with a magnetizable filler.

10. Position measuring device according to any of the preceding claims, wherein the component groups (1; 1', 2) are arranged rotatably about an axis (A) relative to each other and a surface (XY) in which the domain wall conductor (1.211) runs is not intersected by the axis (A).

11. Position measuring device according to any of the preceding claims, wherein the second component group (2) comprises two magnets (2.3, 2.4).

12. Position measuring device according to Claim 11, wherein the magnets (2.3, 2.4)
- are arranged in a row in the measuring direction (x),
- are magnetized such that their magnetization directions (D1, D2; D1', D2') run with orthogonal direction components with respect to the surface (XY),
- are arranged such that they have opposite magnetization directions (D1, D2), wherein
the magnets (2.3, 2.4) are arranged and designed such that the distance (u, U) in the measuring direction (x) between the first magnet (2.3) and the second magnet (2.4) is different at various points along a second direction (y), which is oriented orthogonally with respect to the measuring direction (x).

13. Position measuring device according to Claim 11 or 12, wherein the magnets (2.3, 2.4) are arranged in a row in the measuring direction (x) such that they do not touch each other.

14. Position measuring device according to Claim 11, 12 or 13, wherein there is a fourth distance between the domain wall conductor (1.211) and the magnets (2.3, 2.4), which fourth distance extends orthogonally with respect to a surface (XY) in which the domain wall conductor (1.211) runs,
wherein the fourth distance has a fourth length (S4; S4'), wherein the minimum distance (u) in the measuring direction (x) between the magnets (2.3, 2.4) is smaller than half the fourth length (S4; S4').

15. Position measuring device according to any of Claims 11 to 14, wherein at least one of the magnets (2.3, 2.4) is designed at its end such that its contour is curved.

## Revendications

1. Dispositif de mesure de position comprenant un premier groupe de composants (1 ; 1') et un deuxième groupe de composants (2 ), les groupes de composants (1, 1'; 2 ) étant disposés de manière mobile les uns par rapport aux autres dans une direction de mesure (x),
- le premier groupe de composants (1 ; 1') possédant une première carte de circuit imprimé (1.1), qui comporte une unité de détection (1.11, 1.12, 1.13, 1.14) et
possédant une deuxième carte de circuit imprimé (1.2) qui comporte un conducteur de paroi de domaine (1.211),
la première carte de circuit imprimé (1.1) étant disposée décalée dans la direction de mesure (x) par rapport à la deuxième carte de circuit imprimé (1.2) et
- le deuxième groupe de composants (2) comportant une graduation (2.1, 2.2) et
un aimant (2.3, 2.4),
la graduation (2.1, 2.2) étant disposée entre l'aimant (2.3, 2.4) et la deuxième carte de circuit imprimé (1.2), en vue de déterminer la position relative dans la direction de mesure (x), la graduation (2.1, 2.2) pouvant être palpée par l'unité de détection (1.11, 1.12, 1.13, 1.14) et l'aimant (2.3, 2.4) étant configuré et disposé de telle sorte que celui-ci peut produire un déplacement d'une paroi de domaine dans le conducteur de paroi de domaine (1.211) lors d'un passage de l'aimant (2.3, 2.4).

2. Dispositif de mesure de position selon la revendication 1, le conducteur de paroi de domaine (1.211) étant disposé dans un boîtier (1.213), lequel est monté sur une première surface (O1.2 ; O1.2') de la deuxième carte de circuit imprimé (1.2),
- une première distance entre la graduation (2.1, 2.2) et l'unité de détection (1.11, 1.12, 1.13, 1.14) présentant une première longueur (S1) et
- une deuxième distance entre la première surface (O1.2 ; O1.2') et la graduation (2.1, 2.2) présentant une deuxième longueur (S2 ; S2'), avec pour règle que
la première longueur (S1) est inférieure ou égale à la deuxième longueur (S2 ; S2').

3. Dispositif de mesure de position selon la revendication 1 ou 2,
- une première distance entre la graduation (2.1, 2.2) et l'unité de détection (1.11, 1.12, 1.13, 1.14) présentant une première longueur (S1) et
- une troisième distance entre le conducteur de paroi de domaine (1.211) et la graduation (2.1, 2.2) présente une troisième longueur (S3 ; S3'), avec pour règle que
la première longueur (S1) est inférieure ou égale à la troisième longueur (S3 ; S3').

4. Dispositif de mesure de position selon l'une des revendications précédentes, la première carte de circuit imprimé (1.1) et la deuxième carte de circuit imprimé (1.2) sont respectivement réalisées multicouches, la structure en couches de la première carte de circuit imprimé (1.1) étant différente de la structure en couches de la deuxième carte de circuit imprimé (1.2).

5. Dispositif de mesure de position selon l'une des revendications précédentes, **caractérisé en ce que** le dispositif de mesure de position est basé sur un principe de mesure inductif et l'unité de détection (1.11, 1.12, 1.13, 1.14) possède au moins une piste conductrice de récepteur (1.112, 1.122, 1.132, 1.142).

6. Dispositif de mesure de position selon l'une des revendications précédentes, le dispositif de mesure de position étant conçu comme un dispositif de mesure d'angle.

7. Dispositif de mesure de position selon la revendication 6, **caractérisé en ce que** la première carte de circuit imprimé (1.1) est conçue comme un segment annulaire et s'étend sur un angle d'au moins 180°.

8. Dispositif de mesure de position selon la revendication 6 ou 7, **caractérisé en ce que** la deuxième carte de circuit imprimé (1.2) est conçue comme un segment annulaire et s'étend sur un angle inférieur à 180°.

9. Dispositif de mesure de position selon l'une des revendications précédentes, le matériau de l'aimant (2.3, 2.4) comprend une matière plastique pourvue d'une charge magnétisable.

10. Dispositif de mesure de position selon l'une des revendications précédentes, les groupes de composants (1 ; 1', 2) étant disposés de manière à pouvoir tourner les uns par rapport aux autres autour d'un axe (A) et une surface (XY) dans laquelle s'étend le conducteur de paroi de domaines (1.211) n'est pas coupée par l'axe (A).

11. Dispositif de mesure de position selon l'une des revendications précédentes, le deuxième groupe de composants (2) comprenant deux aimants (2.3, 2.4).

12. Dispositif de mesure de position selon la revendication 11, les aimants (2.3, 2.4)
- étant disposés les uns à la suite des autres dans la direction de mesure (x),
- étant magnétisés de telle sorte que leurs directions de magnétisation (D1, D2 ; D1', D2') suivent un tracé avec une composante directionnelle orthogonale à la surface (XY),
- étant disposés de telle sorte qu'ils présentent des directions de magnétisation (D1, D2) opposées,
les aimants (2.3, 2.4) étant disposés et conçus de telle sorte que la distance (u, U) dans la direction de mesure (x) entre le premier aimant (2.3) et le deuxième aimant (2.4) à différents endroits le long d'une deuxième direction (y), qui est orientée orthogonalement à la direction de mesure (x), soit de valeur différente.

13. Dispositif de mesure de position selon la revendication 11 ou 12, les aimants (2.3, 2.4) étant disposés les uns à la suite des autres dans la direction de mesure (x) de telle sorte qu'ils ne se touchent pas.

14. Dispositif de mesure de position selon la revendication 11, 12 ou 13, une quatrième distance étant présente entre le conducteur de paroi de domaine (1.211) et les aimants (2.3, 2.4), laquelle s'étend orthogonalement à une surface (XY) dans laquelle passe le conducteur de paroi de domaine (1.211),
la quatrième distance présentant une quatrième longueur (S4 ; S4'), la distance minimale (u) entre les aimants (2.3, 2.4) dans la direction de mesure (x) étant inférieure à la moitié de la quatrième longueur (S4 ; S4').

15. Dispositif de mesure de position selon l'une des revendications 11 à 14, au moins l'un des aimants (2.3, 2.4) étant conçu à son extrémité de telle sorte que son contour suit un tracé incurvé.
